# EUROPÄISCHE PATENTSCHRIFT

(11) **EP 0 877 948 B1**
(45) Veröffentlichungstag und Bekanntmachung des Hinweises auf die Patenterteilung: **28.08.2002**
(21) Anmeldenummer: 97914093.6
(22) Anmeldetag: 24.01.1997
(51) Int. Cl.: G01R 31/08

(54) **VERFAHREN ZUM ERFASSEN EINES FEHLERS AUF EINEM ZU ÜBERWACHENDEN LEITUNGSABSCHNITT EINER ELEKTRISCHEN ÜBERTRAGUNGSLEITUNG NACH DEM DISTANZSCHUTZPRINZIP**
METHOD OF DETECTING A FAULT IN A MONITORED SECTION OF AN ELECTRIC TRANSMISSION LINE USING DISTANCE PROTECTION TECHNIQUES
PROCEDE DE DETECTION D'UNE ANOMALIE SUR UNE SECTION SURVEILLEE D'UNE LIGNE ELECTRIQUE DE TRANSMISSION SELON LE PRINCIPE DE LA PROTECTION DE DISTANCE

(30) Priorität: 31.01.1996 DE 19605022
(43) Veröffentlichungstag der Anmeldung: 18.11.1998
(73) Patentinhaber: SIEMENS AKTIENGESELLSCHAFT, 80333 München (DE)
(72) Erfinder: JURISCH, Andreas, D-13587 Berlin (DE); SEZI, Tevfik, D-12169 Berlin (DE)
(86) Internationale Anmeldenummer: DE9700161
(87) Internationale Veröffentlichungsnummer: WO97028454

(56) Entgegenhaltungen:
- EP-A- 0 275 779
- EP-A- 0 358 488
- US-A- 5 455 776
- IEEE TRANSACTIONS ON POWER DELIVERY, Bd. 9, Nr. 3, 1.Juli 1994, Seiten 1352-1358, XP000484966 REDFERN M A ET AL: "A NEW APPROACH TO DIGITAL CURENT DIFFERENTIAL PROTECTION FOR LOW AND MEDIUM VOLTAGE FEEDER CIRCUIT USING A DIGITAL VOICE-FREQUENCY GRADE COMMUNICATIONS CHANNEL"
- IEE PROCEEDINGS, Bd. 133C, Nr. 6, September 1986, Seiten 359-368, XP000674093 COOK V ET AL: "Fundamentals aspects of fault location algorithms used in distance protection" in der Anmeldung erwähnt
- IEEE TRANSACTIONS ON POWER DELIVERY, Bd. 9, Nr. 1, 1.Januar 1994, Seiten 220-230, XP000465627 YANG H -T ET AL: "A NEW NEURAL NETWORKS APPROACH TO ON-LINE FAULT SECTION ESTIMATION USING INFORMATION OF PROTECTIVE RELAYS AND CIRCUIT BREAKERS"
- SIEMENS: 'Digitaler Abzweigschutz SIPROTEC 7SA511 V3.2, Gerätehandbuch', 1995, SIEMENS

## Beschreibung

Die Erfindung bezieht sich auf ein Verfahren zum Erfassen eines Fehlers auf einem zu überwachenden Leitungsabschnitt einer elektrischen Energieübertragungsleitung nach dem Distanzschutzprinzip, bei dem mit jeweils einer Meßanordnung an jedem Ende des zu überwachenden Leitungsabschnittes mit dort erfaßten Strom- und Spannungswerten der Energieübertragungsleitung bei einem Fehler auf dem zu überwachenden Leitungsabschnitt ein Auslösesignal und ein einen in Richtung zum jeweils anderen Ende liegenden Fehler anzeigendes Richtungssignal erzeugt wird und bei dem das Richtungssignal über eine zwischen den Meßanordnungen verlaufende Datenübertragungsleitung mit geringer Übertragungskapazität zu der jeweils anderen Meßanordnung übertragen wird.

Bei einem bekannten Verfahren dieser Art (Siemens-Handbuch "7SA511 V3 Digitaler Abzweigschutz", 1995, Seite 62) wird zum zuverlässigen Erfassen eines Fehlers auf einem zu überwachenden Leitungsabschnitt einer elektrischen Energieübertragungsleitung an beiden Enden des zu überwachenden Leitungsabschnittes nach dem Distanzschutzprinzip im Fehlerfalle jeweils ein Auslösesignal erzeugt und damit ein zugeordneter Leistungsschalter zum Abtrennen des Leitungsabschnittes von der Energieübertragungsleitung veranlaßt. Da von jedem Ende des zu überwachenden Leitungsabschnittes aus ein Fehler mit einem Verfahren nach dem Distanzschutzprinzip nur etwa über 80 % der Länge des zu überwachenden Leitungsabschnittes im Fehlerfalle zuverlässig erfaßt werden kann, wird bei dem bekannten Verfahren an jedem Ende des zu überwachenden Leitungsabschnittes im Fehlerfalle ein Richtungssignal mit der Aussage erzeugt, daß der Fehler in Richtung zum jeweils anderen Ende hin liegt; das Richtungssignal wird über eine Datenübertragungsleitung zum jeweils anderen Ende bzw. zur jeweils anderen Meßanordnung übertragen. Da das Richtungssignal ein einfaches Binärsignal ist oder seriell übertragen wird, benutzt man als Datenübertragungsleitung eine einfache Leitung mit geringer Übertragungskapazität. Mit dem jeweils empfangenen Richtungssignal kann unter Berücksichtigung des am jeweiligen Ende selbst erzeugten Richtungssignals mit hoher Zuverlässigkeit ein Fehler auf dem zu überwachenden Leitungsabschnitt auch dann erkannt werden, wenn der Fehler im jeweiligen End- bzw. Anfangsbereich des zu überwachenden Leitungsabschnittes aufgetreten ist.

Es ist auch aus der europäischen Patentanmeldung EP 0 275 779 A1 eine Schutzanordnung bekannt, bei der an jedem Ende eines zu überwachenden Leitungsabschnittes ein Richtungsrelais vorhanden ist; über einen leitungsfreien Übertragungskanal sind die Richtungsrelais an den Enden des zu überwachenden Leitungsabschnittes miteinander verbunden, um einen Signalaustausch zu ermöglichen.

Es ist darüber hinaus eine Schutzschaltung bekannt (europäische Patentanmeldung EP 0 358 488 A2), bei der an jedem Ende eines zu überwachenden Leitungsabschnittes fehlerrelevante Strom- und Spannungsmeßgrößen erfaßt und über eine Datenverbindung zwischen den beiden Enden ausgetauscht werden. An jedem Ende befindet sich ein Mikroprozessor, mit dem aus den fehlerrelevanten Strom- und Spannungsmeßgrößen der Fehlerort bestimmt wird.

Es ist ferner aus der deutschen Offenlegungsschrift DE 2 112 136 eine Anordnung zum Überwachen eines Leitungsabschnittes einer elektrischen Übertragungsleitung bekannt, die an jedem Ende des zu überwachenden Leitungsabschnittes mit einer Distanzschutzanordnung versehen ist und außerdem eine Schaltungsanordnung zum Messen der Fehlerstellenentfernung aufweist. Die Schaltungsanordnung enthält an jedem Ende des zu überwachenden Leitungsabschnittes einen Speicher, in dem nach Analog-Digital-Wandlung aus der Energieübertragungsleitung abgeleitete Strom- und Spannungswerte gespeichert werden. Im Falle eines Fehlers auf dem zu überwachenden Leitungsabschnitt werden die in dem Speicher gespeicherten Werte über jeweils ein Datenübertragungssystem an eine Auswerteeinrichtung übertragen, der eine Rechenanlage zum Bestimmen des Ortes des Fehlers auf dem zu überwachenden Leitungsabschnitt nachgeordnet ist. Für die Datenübertragung können übliche Fernwirkübertragungseinrichtungen verwendet werden.

Der Erfindung liegt die Aufgabe zugrunde, ein Verfahren zum Erfassen eines Fehlers auf einem zu überwachenden Leitungsabschnitt einer elektrischen Energieübertragungsleitung anzugeben, mit dem sich nicht nur nach dem Distanzschutzprinzip ein Auslösesignal gewinnen läßt, sondern in einfacher Weise auch eine den Ort des Fehlers auf dem zu überwachenden Leitungsabschnitt angebende Meßgröße erzeugen läßt.

Zur Lösung dieser Aufgabe werden bei einem Verfahren der eingangs angegebenen Art erfindungsgemäß in jeder Meßanordnung nach der Abgabe des Auslösesignals zur Berechnung des Fehlerortes geeignete Zwischengrößen bereitgestellt und zur jeweils anderen Meßanordnung über die Datenübertragungsleitung übermittelt; in jeder Meßanordnung wird aus den eigenen und den übermittelten Zwischengrößen eine den Fehlerort angebende Meßgröße gewonnen.

Ein wesentlicher Vorteil des erfindungsgemäßen Verfahrens besteht darin, daß zur genauen Ermittlung des Fehlerortes kein zusätzliches Datenübertragungssystem benötigt wird, sondern auf die für die Übertragung der Richtungssignale bei der Distanzschutzmessung benutzte Datenübertragungsleitung zurückgegriffen werden kann; ein zusätzliches - kostenaufwendiges-Datenübertragungssystem zur Fehlerortsbestimmung ist nicht erforderlich. Die Datenübertragungsleitung kann zur Fehlerortsbestimmung deshalb herangezogen werden, weil nach der Abgabe der Richtungssignale bzw. nach erfolgter Auslösung die Datenübertragungsleitung nicht mehr benötigt wird und daher zur Fehlerortsbestimmung ausgenutzt werden kann. Ermöglicht wird dies dadurch, daß gemäß der Erfindung in den Meßanordnungen zur Fehlerortsbestimmung Zwischengrößen gebildet werden, die zur Berechnung des Fehlerortes geeignet sind. Diese Zwischengrößen lassen sich über die Datenübertragungsleitung mit geringer Übertragungskapazitat ohne weiteres übertragen.

Bei dem erfindungsgemäßen Verfahren können unterschiedliche Zwischengrößen bereitgestellt werden. Als vorteilhaft wird es angesehen, wenn in jeder Meßanordnung eine für den jeweiligen Fehlerort charakteristische Impedanzmeßgröße als Zwischengröße bereitgestellt wird. Die Meßanordnung ist nämlich bei entsprechender Auslegung in der Lage, aus der lediglich von der jeweils anderen Meßanordnung übermittelten Impedanzgröße den Fehlerort genau zu messen. An sich ist diese Art der Fehlerortbestimmung bekannt aus "IEE Proceedings", Vol, Part. C, 133 No. 6, September 1986, Seiten 359 bis 368, insbesondere 363, bekannt.

Bei einer anderen vorteilhaften Ausführungsform des erfindungsgemäßen Verfahrens werden in jeder Meßanordnung für den jeweiligen Fehlerort charakteristische Strom- und Spannungsvektoren als Zwischengröße bereitgestellt. Auch die Übertragung derartiger Zwischengrößen ist über eine Datenübertragungsleitung mit geringer Übertragungskapazität möglich. Ein derartiges Verfahren zur Fehlerortsbestimmung ist ebenfalls für sich aus "IEE Proceedings", Vol. 137, Part C, Nr. 6, November 1990, Seiten 395 bis 402 bekannt.

Zur Erläuterung der Erfindung ist in
- Figur 1: ein Ausführungsbeispiel einer Anordnung zur Durchführung des erfindungsgemäßen Verfahrens, in
- Figur 2: ein weiteres Ausführungsbeispiel einer Anordnung zur Durchführung des erfindungsgemäßen Verfahrens und in
- Figur 3: ein Blockschaltbild zur näheren Erläuterung des Ablaufs eines Ausführungsbeispiels des erfindungsgemäßen Verfahrens gezeigt.

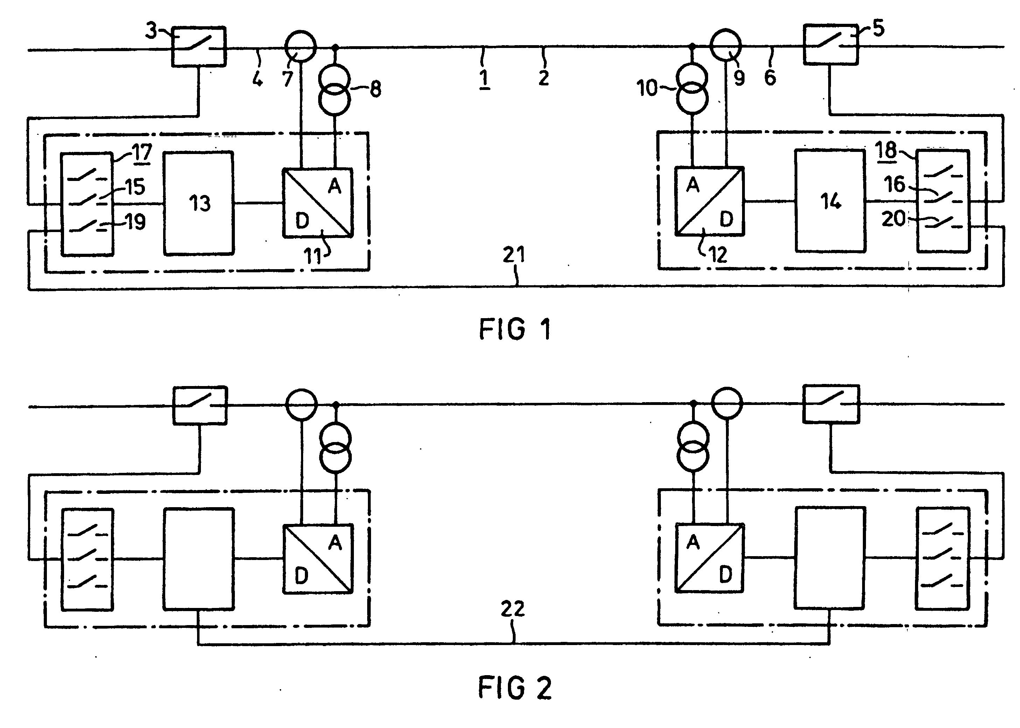

In Figur 1 ist eine elektrische Energieübertragungsleitung 1 zu erkennen, die einen zu überwachenden Leitungsabschnitt 2 aufweist; dieser Leitungsabschnitt 2 ist durch einen Leistungsschalter 3 an einem Ende 4 des Leitungsabschnittes 2 und durch einen weiteren Leistungsschalter 5 am anderen Ende 6 des zu überwachenden Leitungsabschnittes 2 begrenzt. Über einen in der Figur 1 nur schematisch dargestellten Stromwandler 7 und einen Spannungswandler 8 am Ende 4 sowie einen weiteren Stromwandler 9 und einen weiteren Spannungswandler 10 am anderen Ende 6 des zu überwachenden Leitungsabschnittes 2 werden den Strömen und Spannungen der Energieübertragungsleitung 1 entsprechende Ströme und Spannungen einer Analog-Digital-Wandleranordnung 11 an dem einen Ende 4 des Leitungsabschnittes 2 und einer weiteren Analog-Digital-Wandleranordnung 12 am anderen Ende 6 zugeführt. Den Analog-Digital-Wandleranordnungen 11 bzw. 12 ist jeweils eine Meßanordnung 13 bzw. 14 in Form eines Prozeßrechners nachgeordnet.

Die Energieübertragungsleitungleitung 1 ist der besseren Übersichtlichkeit halber einphasig dargestellt; tatsächlich ist sie dreiphasig ausgebildet, weshalb auch entsprechend viele Strom- und Spannungswandler vorgesehen sind, um die benötigten Meßgrößen zu erfassen.

In den Meßanordnungen 13 und 14 wird aus den ihnen zugeführten digitalisierten Strom- und Spannungswerten im Falle eines Fehlers, beispielsweise eines Kurzschlusses, auf dem zu überwachenden Leitungsabschnitt 2 jeweils ein Auslösesignal erzeugt, durch das jeweils ein Schaltkontakt 15 bzw. 16 jeweils einer Schalteinrichtung 17 bzw. 18 betätigt wird. Dadurch wird ein Betätigungsimpuls an die Leistungsschalter 3 bzw. 5 gegeben und diese zum Öffnen veranlaßt, wodurch der zu überwachende Leitungsabschnitt 2 aus der Energieübertragungsleitung 1 herausgetrennt wird. Über weitere Schaltkontakte 19 bzw. 20 der Schalteinrichtung 17 bzw. 18 wird über eine Datenübertragungsleitung 21 mit geringer Übertragungskapazität ein Richtungssignal binär von der einen Meßanordnung 13 zur anderen Meßanordnung 14 und von der anderen Meßanordnung 14 zur einen Meßanordnung 13 übertragen.

Nachdem von den Meßanordnungen 13 bzw. 14 ein Auslösesignal erzeugt worden ist, bei dessen Gewinnung gegebenenfalls die über die Datenübertragungsleitung 21 ausgetauschten Richtungssignale berücksichtigt worden sind, wird die Datenübertragungsleitung 21 zur Fehlererfassung nach dem Distanzschutzprinzip nicht mehr benötigt. Sie wird gemäß der Erfindung nunmehr zur binären Übertragung von Zwischengrößen zur Fehlerortsbestimmung ausgenutzt, indem die Meßanordnungen 13 bzw. 14 nach der Abgabe von Auslösesignalen diese Zwischengrößen zur Fehlerortsbestimmung bereitstellen. Da diese Zwischengrößen nur aus einer Impedanzmeßgröße bzw. aus einem Impedanzvektor oder aus Strom- und Spannungsvektoren bestehen, kann die Datenübertragungsleitung 21 ohne weiteres zur Übertragung dieser Zwischengrößen verwendet werden, so daß die Meßanordnungen 13 bzw. 14 nunmehr nach den oben angegebenen, an sich bekannten Verfahren zur Fehlerortsbestimmung mittels der empfangenen Zwischengrößen eine genaue Fehlerortsbestimmung von beiden Enden des zu überwachenden Leitungsabschnittes und damit mit hoher Genauigkeit durchführen können.

Das Ausführungsbeispiel nach Figur 2 stimmt im wesentlichen mit dem nach Figur 1 überein. Die wesentliche Abweichung des Ausführungsbeispiels nach Figur 2 von dem nach Fig. 1 besteht darin, daß eine Datenübertragungsleitung 22 mit geringer Übertragungskapazität hier als ein serieller Übertragungskanal benutzt wird. Die zur Fehlerortsbestimmung erforderlichen Zwischengrößen werden hier seriell zwischen den Meßanordnungen 13 und 14 über die Datenübertragungsleitung 22 ausgetauscht.

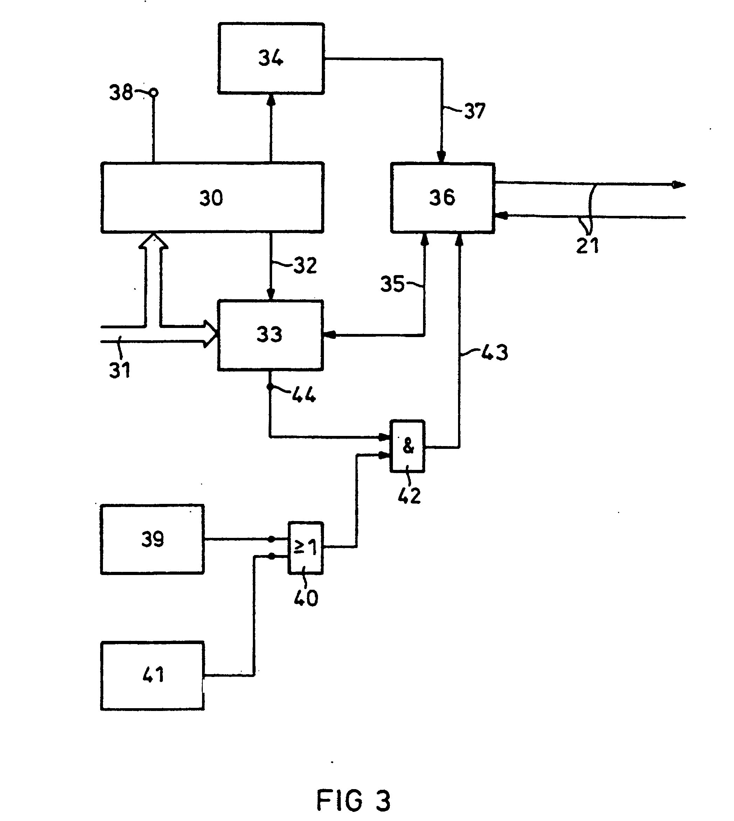

Das Ausführungsbeispiel nach Figur 3 dient - wie oben bereits angemerkt wurde - nur dazu, den jeweils in den Meßanordnungen 13 bzw. 14 ablaufenden Prozeß zu veranschaulichen; die einzelnen Blöcke dieser Figur sind daher nicht als Schaltungseinheiten zu betrachten, sondern stellen lediglich Funktionsblöcke dar. In der Figur 3 ist dabei auch nur auf die Wirkungsweise einer Meßanordnung 13 bzw. 14 an einem Ende des zu überwachenden Leitungsabschnittes Bezug genommen, weil an dem jeweils anderen Ende das Verfahren in entsprechender Weise abläuft.

Die Figur 3 läßt erkennen, daß einem die Distanzschutzmessung durchführenden Block 30 über einen Datenbus 31 von der nicht dargestellten Analog-Digital-Wandleranordnung 11 bzw. 12 nach Figur 1 abgegebene Daten zugeführt werden. In dem Block 30 wird im Falle eines erfaßten Fehlers auf dem zu überwachenden Leitungsabschnitt nicht nur ein Anregesignal erzeugt und über eine Verbindung 32 an einen Block 33 zur Fehlerortsbestimmung gegeben, sondern es wird auch einem Block 34 zum Signalvergleich ein Richtungssignal übermittelt.

Der Block 33 zur Fehlerortsbestimmung liegt ebenfalls an dem Datenbus 31 und erzeugt Strom- und Spannungsvektoren I und U, die sowohl den Zustand des zu überwachenden Leitungsabschnittes vor dem Auftreten eines Fehlers als auch während eines Fehlers wiedergeben. Der Block 33 ist über eine Verbindung 35 an eine Schaltvorrichtung 36 angeschlossen, über die die Datenübertragungsleitung 21 nach Figur 1 bzw. 22 nach Figur 2 wahlweise mit dem Block 34 oder dem Block 33 verbunden werden kann. Die Schaltvorrichtung 36 ist normalerweise so geschaltet, daß die Datenübertragungsleitung 21 über eine Verbindung 37 an den Block 34 angeschlossen ist.

Ist nach Anregung ein Auslösebefehl von dem Block 30 über einen Ausgang 38 an einen nicht gezeigten Leistungsschalter 3 bzw. 5 abgegeben worden, dann ist der Leistungsschalter 3 bzw. 5 geöffnet. Durch einen Detektor 39 zur Erfassung des Öffnungszustands des jeweiligen Leistungsschalters 3 bzw. 5 wird der geöffnete Zustand erfaßt und ein entsprechendes Signal an einen Eingang eines Logik-Gliedes 40 gegeben, an dessen weiteren Eingang ein Monitor 41 zur Überprüfung des Zustandes einer automatischen Wiedereinschaltungsvorrichtung angeschlossen ist. Dem Logik-Glied 40 ist ein UND-Glied 42 nachgeordnet, das über eine Verbindung 43 dann einen Umschaltbefehl an die Schaltvorrichtung 36 gibt, wenn sowohl an dem Ausgang des Logik-Gliedes 40 als auch an einem Ausgang 44 des Blockes 33 zur Fehlerortsbestimmung ein Signal ansteht.

Nach Umschaltung der Schaltvorrichtung 36 ist die Datenübertragungsleitung 21 direkt mit dem Block 33 über die Verbindung 35 angeschlossen, so daß ein Austausch der Zwischengrößen zur Fehlerortsbestimmung in Form von Strom- und Spannungsvektoren erfolgen kann. In dem Block 33 wird aus den jeweils dort erfaßten Größen und den empfangenen Zwischengrößen eine den Fehlerort genau angebende Meßgröße gewonnen.

## Patentansprüche

1. Verfahren zum Erfassen eines Fehlers auf einem zu überwachenden-Leitungsabschnitt einer elektrischen Energieübertragungsleitung nach dem Distanzschutzprinzip, bei dem
- mit jeweils einer Meßanordnung an jedem Ende des zu überwachenden Leitungsabschnittes mit dort erfaßten Stromund Spannungswerten der Energieübertragungsleitung bei einem Fehler auf dem zu überwachenden Leitungsabschnitt ein Auslösesignal und ein einen in Richtung zum jeweils anderen Ende liegenden Fehler anzeigendes Richtungssignal erzeugt wird und bei dem
das Richtungssignal über eine zwischen den Meßanordnungen verlaufende Datenübertragungsleitung mit geringer Übertragungskapazität zu der jeweils anderen Meßanordnung übertragen wird,
**dadurch gekennzeichnet, daß**
- in jeder Meßanordnung (13,14) nach der Abgabe des Auslösesignals zur Berechnung des Fehlerortes geeignete Zwischengrößen (I, U) bereitgestellt werden,
- die Zwischengrößen (I, U) zur jeweils anderen Meßanordnung (z.B. 14) über die Datenübertragungsleitung (21) übermittelt werden und
- in jeder Meßanordnung (13,14) aus den eigenen und den übermittelten Zwischengrößen (I,U) eine den Fehlerort angebende Meßgröße gewonnen wird.

2. Verfahren nach Anspruch 1,
**dadurch gekennzeichnet, daß**
- in jeder Meßanordnung eine für den jeweiligen Fehlerort charakteristische Impedanzmeßgröße als Zwischengröße bereitgestellt wird.

3. Verfahren nach Anspruch 1,
**dadurch gekennzeichnet, daß**
- in jeder Meßanordnung (13,14) für den jeweiligen Fehlerort charakteristische Strom- und Spannunsvektoren (I, U) als Zwischengröße bereitgestellt werden.

## Claims

1. Method for detecting a fault on a line section, to be monitored, of an electric power transmission line using the distance protection principle, in which
- in the case of a fault on the line section to be monitored, a tripping signal and a direction signal are generated using in each case one measuring arrangement at each end of the line section to be monitored with current and voltage values detected there, and in which the direction signal is transmitted via a data transmission line, running between the measuring arrangements and having a low transmission speed, to the respective other measuring arrangement, **characterized in that**
- intermediate variables (I, U) suitable for calculating the fault location are provided in each measuring arrangement (13,14) after the output of the tripping signal,
- the intermediate variables (I, U) are transmitted to the respective other measuring arrangement (for example 14) via the data transmission line (21), and
- a measured variable specifying the fault location is obtained in each measuring arrangement (13,14) from the own and the transmitted intermediate variables (I, U).

2. Method according to Claim 1, **characterized in that**
- a measured impedance variable characteristic of the respective fault location is provided as intermediate variable in each measuring arrangement.

3. Method according to Claim 1, **characterized in that**
- current and voltage vectors (I, U) characteristic of the respective fault location are provided as intermediate variable in each measuring arrangement (13,14).

## Revendications

1. Procédé pour la détection d'un défaut sur un tronçon de ligne à surveiller d'une ligne de transmission d'énergie électrique selon le principe de la protection à distance,
- dans lequel, par respectivement un dispositif de mesure à chaque extrémité du tronçon de ligne à surveiller, avec des valeurs de courant et de tension qui y sont détectées pour la ligne de transmission d'énergie, on produit en présence d'un défaut sur le tronçon de ligne à surveiller un signal de déclenchement et un signal de direction indiquant un défaut situé dans la direction de l'autre extrémité respective,
et dans lequel le signal de direction est transmis vers l'autre dispositif de mesure respectif par l'intermédiaire d'une ligne de transmission de données s'étendant entre les dispositifs de mesure et ayant une petite capacité de transmission,
**caractérisé par le fait que**
- on fournit dans chaque dispositif de mesure (13, 14) après la délivrance du signal de déclenchement des grandeurs intermédiaires (I, U) convenant au calcul du lieu du défaut,
- on transmet les grandeurs intermédiaires (I, U) à l'autre dispositif de mesure respectif (par exemple 14) par l'intermédiaire de la ligne de transmission de données (21), et
- on obtient dans chaque dispositif de mesure (13, 14) à partir des grandeurs intermédiaires propres (I, U) et des grandeurs intermédiaires transmises (I, U) une grandeur de mesure indiquant le lieu du défaut.

2. Procédé selon la revendication 1,
**caractérisé par le fait que**,
- dans chaque dispositif de mesure, on fournit comme grandeur intermédiaire une grandeur mesurée d'impédance caractéristique du lieu respectif du défaut.

3. Procédé selon la revendication 1,
**caractérisé par le fait que**,
- dans chaque dispositif de mesure (13, 14), on fournit comme grandeur intermédiaire des vecteurs de courant et de tension (I, U) caractéristiques du lieu respectif du défaut.
